# EUROPEAN PATENT APPLICATION

(11) **EP 1 605 508 A2**
(43) Date of publication of application: **14.12.2005**
(21) Application number: 05104934.4
(22) Date of filing: 07.06.2005
(51) Int. Cl.: H01L 27/02, H01L 27/08

(54) **Surface-mount chip-scale package**

(30) Priority: 07.06.2004 US 862710
(71) Applicant: M/A-COM, INC., Lowell, MA 01853 (US)
(72) Inventor: Brogle, James Joseph, Woburn, MA Massachusetts 01801 (US); Boles, Timothy Edward, Tyngsboro, MA Massachussets 01879 (US); Goodrich, Joel Lee, Westford, MA Massachussets 01886 (US)
(74) Representative: Johnstone, Douglas Ian

(57) **Abstract**

A chip-scale package (100) and method of manufacturing a chip-scale package are provided. The chip-scale package includes a mounting portion defined by a plurality of metal layers formed on each of a plurality of semiconductor regions (108) for mounting a device thereto. The mounting portions (104 and 106) are formed on a first side of the plurality of semiconductor regions. The chip-scale package (100) further includes a backside metal surface (110) formed on each of a second side of the plurality of semiconductor regions (108), with the plurality of semiconductor regions (108) providing electrical connection between the mounting portions (104 and 106) and the backside metal surfaces (110).

## Description

This invention relates generally to chip-scale packages, and more particularly, to chip-scale packages for electronic devices.

Chip-scale packages allow components, for example, semiconductor chips to be assembled and packaged in packages with smaller footprints. However, because wire bonding is often required in these packages, for example, to connect protection circuits to power devices within the packages, additional space is needed. This additional space needed to accommodate the wiring and connections results in a larger package size. Further, the wire bonds are often a source of failure within these packages. Additionally, these chip-scale packages typically include metal or plastic housings with the components therein connected to an external device, for example, a printed circuit board (PCB). This external connection requires wire bonding or a reorientation of the package prior to connecting to the PCB. This adds cost and complexity to the package design.

For example, zener diodes, sometimes referred to as avalanche diodes, are known for use in protecting electronic circuits. Zener diodes are used to clamp voltages and suppress electrical surges, such as electrical overstress (EOS) or electrostatic discharge (ESD). Such zener diodes may be used to protect, for example, light-emitting diodes (LEDs) in a chip-scale package. However, the zener diodes are connected by wire bonding, which adds cost and reduces the reliability of these packages. The size of these packages are larger because of the extra space needed for the wire bonding and because they are typically encapsulated within a housing. Thyristors, Shockley diodes and other such "latch-up" devices also may be used as EOS/ESD protection elements.

Other components also may be added to these packages. For example, in addition to providing components for EOS or ESD protection, components may be added to provide heat removal using heat-sinking components. Thus, in addition to electrical connections, for example, for connecting protection circuits within the packages, thermal connections may be required, which together with the electrical connections may be provided as a sub-mount or other suitable assembly. However, the sub-mount must be connected via wire bonding to the power device (e.g., LED) and the complete sub-assembly mounted and encapsulated in a final assembled package. Thereafter, the final assembled package is connected to, for example, a PCB using wire bonding.

Thus, when assembling electronic devices and other components into packages, and particularly when packaging power devices, the use of a metal lead-frames/substrates and wire bonds for interconnections are required. Further, encapsulation of the devices and components is needed. This results in a larger overall package size with a greater likelihood of failure due to the wire bond connections. The cost to manufacture these packages also is higher due to the additional required connections.

The solution is provided by a chip-scale package that includes a mounting portion defined by a plurality of metal layers formed on each of a plurality of semiconductor regions for mounting a device thereto. The mounting portions are formed on a first side of the plurality of semiconductor regions. The chip-scale package further includes a backside metal surface formed on each of a second side of the plurality of semiconductor regions, with the plurality of semiconductor regions providing electrical connection between the mounting portions and the backside metal surfaces.

The invention will now be described by way of example with reference to the accompanying drawings in which:

Figure 1 is a cross-sectional side view of a chip-scale package in accordance with an exemplary embodiment of the invention;

Figure 2 is a top plan view of the chip-scale package of Figure 1;

Figure 3 is a schematic diagram of a plurality of protection elements in accordance with an exemplary embodiment of the invention;

Figure 4 is a schematic diagram of a protection element in accordance with another exemplary embodiment of the invention;

Figure 5 is a schematic diagram of a protection element in accordance with another exemplary embodiment of the invention; and

Figure 6 is a top plan view of a chip-scale package in accordance with another exemplary embodiment of the invention.

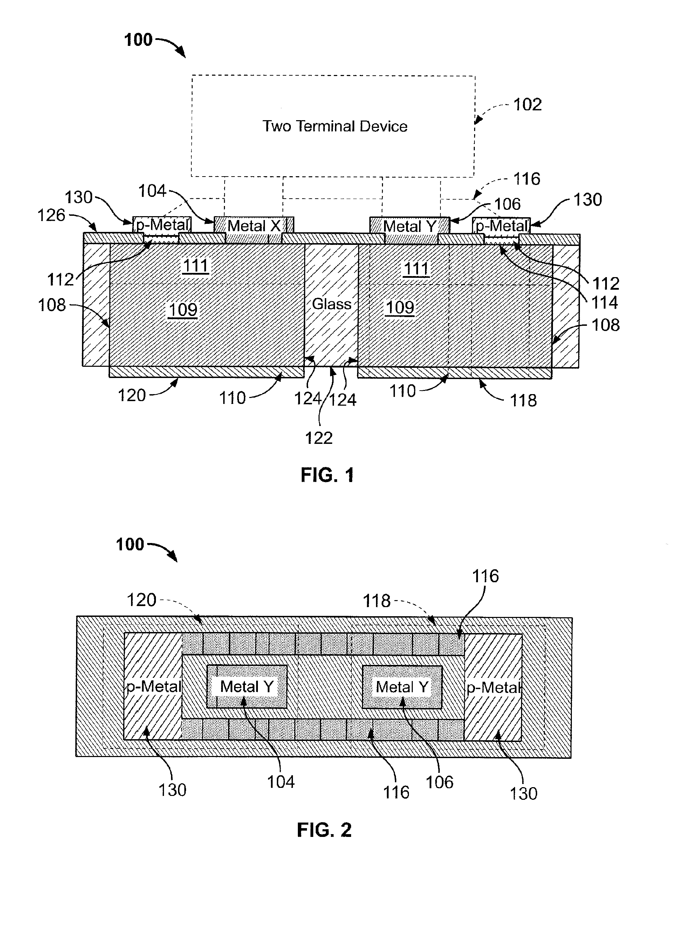

Figures 1 and 2 illustrate a chip-scale package 100 in accordance with an exemplary embodiment of the invention. The chip-scale package 100 provides a monolithic design wherein wire bonds and encapsulation are not needed. However, encapsulation may be provided if desired. As shown, a two-terminal device 102, for example, a two-terminal power electronic device such as a light-emitting diode (LED), diode, thyristor, etc., may be mounted to the chip-scalc package 100 at mounting portions 104 and 106 on a first side of the chip-scale package 100. The two-terminal device 102 may be mounted to the chip-scale package using any suitable conductive connection material, such as, for example, a solder or conductive epoxy. In one embodiment, the mounting is provided with a gold-tin (Au-Sn) solder.

The mounting portions 104 and 106 are defined by metal portions constructed of metal layers, as described in more detail herein, that are in electrical (ohmic) contact with N-type semiconductor regions 108, for example, an N-type silicon doped with antimony, arsenic or phosphorous. The N-type semiconductor regions 108 provide electrical and/or thermal connection between the two-terminal device 102 and a backside metal surface 110 on a second side of the chip-scale package 100. The backside metal surface 110 is connected (e.g., soldered) to, for example, a printed circuit board (PCB) or heat sink (not shown). In one exemplary embodiment, the N-type semiconductor regions 108 are defined by a lower N+ silicon substrate layer 109 and an upper N- silicon epitaxial layer 111.

P-type semiconductor regions 112, for example, P+ silicon doped with boron, aluminum or gallium, form a zener PN junction 114 with the N-type semiconductor regions 108, and more particularly, with the upper N- silicon epitaxial layer 111. It should be noted that the P-type semiconductor regions 112 may be formed by any suitable means, including, for example, diffusion, implantation or epitaxy. For example, an ultrahigh-vacuum/chemical vapor deposition (LTHV/CVD) epitaxy process may be used as described herein. Further, the N-type semiconductor regions 108 in various embodiments may be heavily doped, lightly doped, or may include a lightly doped epitaxy on a heavily doped substrate.

In one embodiment, the doping level of the N-type semiconductor regions 108 near the P-type semiconductor regions 112 is selected such that the breakdown voltage of the PN junction 114 is slightly greater (e.g., ten percent greater) than the operating voltage of the two-terminal device 102 to be mounted to the mounting portions 104 and 106. It should be noted that in another embodiment, the N-type semiconductor regions 108 and P-type semiconductor regions 112 may be reversed.

The P-type semiconductor regions 112 are electrically connected to each other by a metal bridge 116 that is electrically isolated from the N-type semiconductor regions 108 and the two-terminal device 102. Specifically, P-metal regions 130 of the P-type semiconductor regions 112 are electrically connected by the metal bridge 116.

A first semiconductor region 118 and a second semiconductor region 120, each defined by a N-type semiconductor region 108 and a P-type semiconductor region 112, and which also are referred to as mesas, are separated by a dielectric material 122, such as, for example, glass. Side walls 124 of the first semiconductor region 118 and second semiconductor region 120 may be generally vertical as shown in Figure 1 or may be configured at an angle relative to the chip-scale package 100. The angle of the side walls 124 may be modified based on the configuration of the chip-scale package 100. For example, the angle of the side walls 124 may be determined to minimize the size and/or maximize the packing of the chip-scale package 100 based on the type of two-terminal device 102 to be connected thereto.

The chip-scale package 100 is covered in a dielectric isolation layer 126, except at regions where electrical contact to the first semiconductor region 118 and the second semiconductor region 120 is desired or needed. Specifically: (i) the mounting portions 104 and 106 are in contact with the N-type semiconductor regions 108 and (ii) P-metal portions 130, which are the exposed portions of the P-type semiconductor regions 112, are not covered by the dielectric isolation layer 126. In addition, a second dielectric layer (not shown) may be used, covering the P-metal portions 130 and metal bridges 116, but not covering mounting portions 104 and 106.

Having described the structure of the chip-scale package 100, a process for fabricating or forming the chip-scale package 100 in accordance with an exemplary embodiment of the invention will now be described. The process is generally a heterolithic microwave integrated circuit (HMIC) package process. It should be noted that unless otherwise stated, the process steps are performed on top of a silicon wafer.

In the exemplary embodiment, an N- silicon epitaxial layer 111 is formed on a N+ silicon substrate 109 (e.g., silicon wafer). Thereafter, nitride deposition is performed on top of the epitaxial layer 111, which forms a mask layer used to construct the silicon mesas, for example, to construct the first semiconductor region 118 and second semiconductor region 120. The masking layer is formed to approximately 0.15 micrometers (µm), referred to hereafter as a microns. A photolithography and nitride/silicon etch process, as are known, are then performed to create the silicon mesas.

Next, conductive sides of the mesas are formed through N-type deposition and diffusion (e.g., phosphorous deposition and diffusion), which creates a low resistivity surface on the silicon surface. Thereafter, through application of a metal or metal silicide (e.g., cobalt silicide), the resistivity of the silicon surface is further reduced. Then a boro-silicate glass is applied to the silicon surface. Following this the glass is ground and polished so as to planarize the silicon wafer and expose the silicon mesas.

Another masking layer is then formed that is used to create the P-type semiconductor regions 112, which in various embodiments is a P+ silicon layer. Specifically, a low temperature oxide (LTO) deposition is performed, forming a layer of approximately 0.2 microns, followed by a polysilicon deposition forming a layer of approximately 0.18 microns. A photolithography and poly/LTO etch process is then performed to form an opening wherein a P+ epitaxial layer is to be formed, and in particular the P-type semiconductor regions 112.

A UHV/CVD epitaxy process is thereafter performed that forms the anode of a diode, which in one embodiment is a zener diode, that is created by the PN junction 114. It should be noted that the N- silicon epitaxial layer 111 formed earlier in the process is the cathode of the zener diode. In one exemplary embodiment, the UHV/CVD epitaxy process forms the anode of an HMIC PN zener diode and is performed at a temperature of about 500 degrees Celsius (C). Thereafter, the masking layer is removed using a photolithography and etching process that removes excess polysilicon and oxide. It should be noted that different types and kinds of components may be monolithically formed as described herein and the various embodiments of the invention are not limited to forming a zener diode. For example, monolithically integrated PIN diodes, Schottky diodes, transistors, thyristors, resistors, inductors, capacitors, transmission lines, etc. may be monolithically formed using the embodiments described herein.

A plurality of metal layers are thereafter formed that create the mounting portions 104 and 106, and the P-metal regions 130. Specifically, a contact metal photolithography, deposition and liftoff process is performed that defines the metal portions on top of the first semiconductor region 118 and second semiconductor region 120. Specifically, a first metal pattern in formed on the silicon, which in one embodiment, is defined by a titanium (Ti) layer between two platinum (Pt) layers (i.e., Pt/Ti/Pt pattern). Thereafter, a second metal pattern is formed by a metal photolithography, deposition and liftoff process wherein a Ti layer is formed on a Pt layer, which is formed on a gold (Au) layer (i.e., Ti/Pt/Au pattern).

A nitride deposition process is then performed that forms a dielectric between the second metal pattern and a third metal pattern to be formed, as described below. In one exemplary embodiment, a nitride layer of approximately 0.6 microns is formed. A nitride photolithography and etching process is then performed to expose an opening, and more specifically, a contact window between the second metal pattern and the third metal pattern. Thereafter, a third metal pattern is formed by a metal photolithography, deposition and liftoff process wherein a Ti layer is formed on a Pt layer, which is formed on an Au layer (i.e., Ti/Pt/Au pattern). This third metal pattern forms the metal bridge 116.

A nitride deposition process is again performed to form a protective layer. In one exemplary embodiment, the deposition forms a layer of approximately 0.6 microns. Thereafter, a nitride photolithography and etching process is performed to expose the metal layers at the mounting portions 104 and 106, on which a plurality of additional metal layers are deposited. Specifically, a plurality of tin (Sn) and Au layers are deposited through a photolithography, plating or liftoff process, which in one exemplary embodiment defines seven layers each of Sn and Au (i.e., Sn/Au/Sn/Au/Sn/Au/Sn/Au/Sn/Au/Sn/Au/Sn/Au pattern). These metal layers provide a surface onto which may be mounted (e.g., soldered), for example, an LED. It should be noted that these metal layers are plated only on the mounting portions 104 and 106.

Thereafter, a wafer grind process is performed to grind off the back of the silicon wafer to a thickness of, for example, 125 microns, which also isolates each silicon mesa (e.g., isolates the first semiconductor region 118 and the second semiconductor region 120). A backside photolithography, deposition and liftoff process is then performed to create the backside metal surface 110 that defines a contact surface on the bottom of the chip-scale package 100, which may used, for example, for mounting the chip-scale package 100 to a PCB. Finally, the chip-scale packages are singulated (e.g., the wafer is diced to separate individual chip-scale packages).

A monolithic chip-scale package 100 is thereby formed without a housing (e.g., plastic or metal housing) and which may be mounted directly to, for example, a PCB without wire bonding or flipping over the package. Specifically, in the various embodiments, the silicon forms an electrical connection between the top or first side of the chip-scale package 100 and the bottom or second side of the chip-scale package 100. Thus, an electrical connection between, for example, a LED mounted on top of the chip-scale package 100 using the mounting portions 104 and 106, and a PCB on which the chip-scale package 100 is mounted, may be provided without wire bonding and without the need for encapsulation (e.g., plastic or metal housing). Furthermore, components may be monolithically integrated in the chip-scale package 100 during the fabrication process, for example, monolithic integration of a zener diode as described herein, without wire bonding. However, it should be noted that the chip-scale package 100 may be fabricated without such components integrated therein. It also should be noted that the electronic device 102 may be mounted in-situ to the chip-scale packages 100 in wafer-form (e.g., during the fabrication process) before the chip-scale packages are singulated, thus further reducing assembly complexity and costs. The completed assembly also may be electrically tested in-situ before singulation.

The process for fabricating chip-scale packages may be modified as desired or needed, for example, based on the application and/or type of device to be connected to the chip-scale package. Further, it should be noted that intermediate cleaning processes, as are known, also may be performed during the fabrication of the chip-scale package 100.

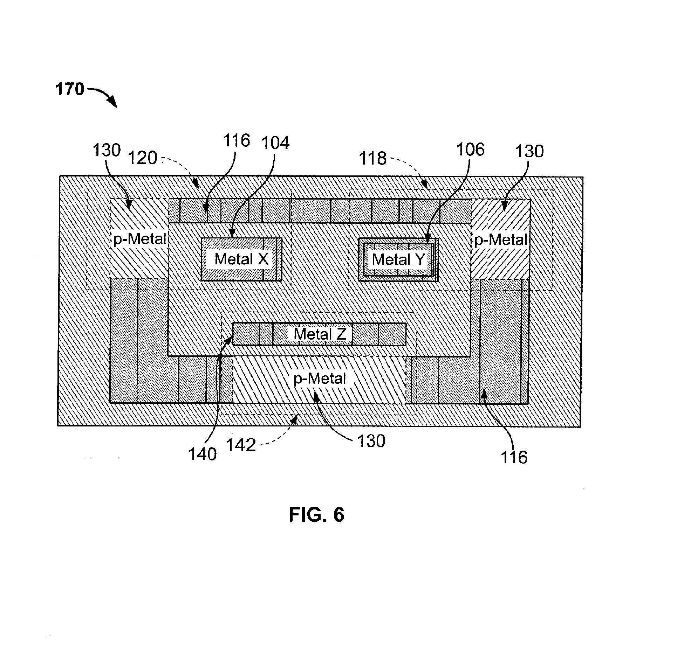

Also, the various embodiments may be modified for use in connection with different devices having different numbers of terminals. For example, a chip-scale package 170 may be formed for use in connection with devices having more than two terminals, such as for example, for mounting thereon three-terminal devices (e.g., a power transistor) as shown in Figure 6. The process as described herein is modified to fabricate three separate mesas defined by first semiconductor region 118, second semiconductor region 120, and third semiconductor region 142 having mounting portions 104, 106 and 140, respectively.

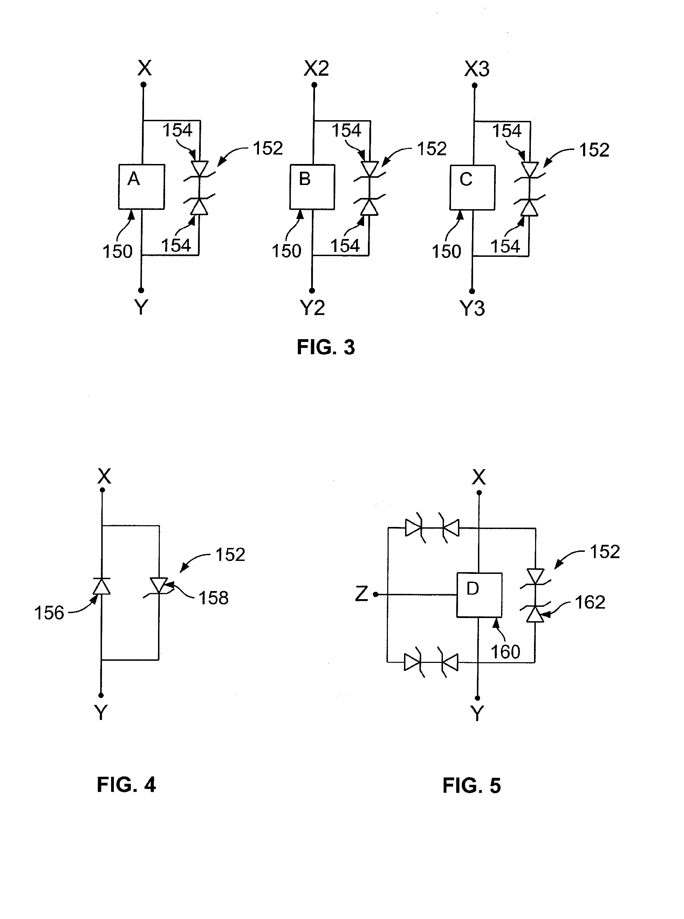

One or more devices may be mounted on a single chip-scale package 100, with each device having a corresponding protection element associated therewith. For example, as shown in Figure 3, a plurality of devices 150 (e.g., LEDs) may be mounted to a single chip-scale package 100 having mounting portions as described herein for mounting thereto the terminals of the devices, shown as X and Y, X2 and Y2, and X3 and Y3 for each of the devices 150. The protection element 152 may be formed, for example, by monolithically integrated zener diodes 154 as described herein, and shown connected in a common cathode arrangement. However, the protection element 152 may be integrated in different configurations, for example, in a common anode arrangement or as a thyristor, Shockley diode or other such "latch-up" device.

As another example, if the device to be connected to the chip-scale package 100 is a diode 156 as shown in Figure 4, the protection element 152 may be a monolithically integrated single zener diode 158 as described herein, or a thyristor, Shockley diode or other such "latch-up" device. In this arrangement, the zener diode 158 is connected in the opposite direction to the diode 156. It should be noted that the terminals of the diode 156, identified as X and Y in Figure 4, may be mounted to mounting portions 104 and 106 (shown in Figures 1 and 2), or vice versa.

As still another example, if the device to be connected is a three-terminal device 160 as shown in Figure 5, then the chip-scale package 170 may be used with the terminals of the three-terminal device 160 mounted to the three mounting portions 104, 106 and 140 (shown in Figure 6). The protection element 152 may be monolithically integrated pairs of zener diodes 162 connected in a common cathode configuration. However, the pairs of zener diodes 162 also may be connected in different arrangements, for example, in a common anode configuration, or may be replaced by thyristors, Shockley diodes or other such "latch-up" devices.

Additionally, the number of devices and protection elements may be modified based on design requirements, package size limitations, etc. Further, a protection element need not be integrated in connection with each of the mounting portions, for example, if the device to be connected thereto does not require a protection element. Also, different types of components may be monolithically integrated into chip-scale packages as described herein, such as, for example, monolithically integrating PIN diodes, Schottky diodes, transistors, thyristors, resistors, inductors, capacitors, transmission lines, etc. into chip-scale packages.

Thus, monolithic chip-scale packages may be provided without encapsulation and without the use of wire bonding for mounting to a device, for example, a PCB. Further, protection elements may be monolithically integrated therein without wire bonding. Also, electronic devices may be mounted in-situ to the chip-scale packages in wafer-form (e.g., during the fabrication process) before the chip-scale packages are singulated.

While the invention has been described in terms of various specific embodiments, those skilled in the art will recognize that the invention can be practiced with modification within the scope of the claims.

## Claims

1. A chip-scale package (100) comprising:
a mounting portion (104,106) defined by a plurality of metal layers formed on each of a plurality of semiconductor regions (108) for mounting a device thereto, the mounting portion (104,106) formed on a first side of the plurality of semiconductor regions (108); and
a backside metal surface (110) formed on each of a second side of the plurality of semiconductor regions (108), with the plurality of semiconductor regions (108) providing electrical connection between the mounting portions (104, 106) and the backside metal surfaces (110).

2. A chip-scale package in accordance with claim 1 further comprising a P-type epitaxial layer (112) formed on at least one of the plurality of semiconductor regions (108) and defining an anode of a diode, wherein the plurality of semiconductor regions (108) comprise a silicon epitaxial layer defining a cathode of the diode.

3. A chip-scale package in accordance with claim 1 or 2 further comprising a metal bridge (116) connecting the plurality of semiconductor regions (108).

4. A chip-scale package in accordance with claim 1, 2 or 3 wherein the plurality of metal layers comprise tin and gold layers for mounting a device thereto.

5. A chip-scale package in accordance with any preceding claim further comprising a dielectric material (122) separating the plurality of semiconductor regions (108).

6. A chip-scale package in accordance with any preceding claim wherein walls of the plurality of semiconductor regions (108) are formed in a substantially vertical arrangement.

7. A chip-scale package in accordance with any preceding claim wherein walls of the plurality of semiconductor regions (108) are formed in an angled arrangement.

8. A chip-scale package in accordance with any preceding claim wherein at least one of the plurality of semiconductor regions (108) comprises one of a monolithically integrated PIN diode, Schottky diode, zener diode, transistor, thyristor, resistor, inductor, capacitor, and transmission line.

9. A chip-scale package in accordance with any preceding claim wherein the first side is a top side and the second side is a bottom side.

10. A chip-scale package in accordance with any preceding claim wherein the plurality of semiconductor regions (108) are configured to provide thermal connection between the mounting portions (104, 106) and the backside metal surfaces (110).
